Europäisches Patentamt

European Patent Office

Office européen des brevets

(11) Publication number: **0 296 828**
**A2**

## (12) EUROPEAN PATENT APPLICATION

(21) Application number: **88305693.9**

(51) Int. Cl.⁴: **H03M 13/00**

(22) Date of filing: **22.06.88**

(30) Priority: **22.06.87 JP 155190/87**
**23.06.87 JP 156166/87**

(43) Date of publication of application:
**28.12.88 Bulletin 88/52**

(84) Designated Contracting States:
**AT DE FR GB NL**

(71) Applicant: **SONY CORPORATION**
**7-35 Kitashinagawa 6-Chome Shinagawa-ku**
**Tokyo 141(JP)**

(72) Inventor: **Shirota, Norihisa**
**c/o Sony Corporation 7-35 Kitashinagawa**
**6-chome**
**Shinagawa-ku Tokyo(JP)**

(74) Representative: **Ayers, Martyn Lewis Stanley**
**et al**
**J.A. KEMP & CO. 14 South Square Gray's Inn**
**London, WC1R 5EU(GB)**

(54) **Method and apparatus for decoding reed-solomon code.**

(57) Decoding for the Reed-Solomon Code in which syndromes are calculated by a parity check matrix and a received word, an error location polynomial $\sigma(x)$ and an error evaluation polynomial $\omega(x)$ are calculated, an error pattern $e_p$ is obtained using a formal first-order differential polynomial $\sigma'(x)$ of the error location polynomial $\sigma(x)$ and the error evaluation polynomial $\omega(x)$, and a symbol of an error position p is corrected. Even number terms and odd number terms of the error location polynomial are separated and predetermined values are put into each x of the separated even number terms and $\sigma(\alpha^{-m})$ and $\sigma'(\omega^{-m})$ are produced simultaneously erasure correction is made by regarding points as corrected when a condition of

$$\deg \sigma^*(x) > \deg \omega^*(x)$$

is established based on $\omega^*(x) = \sigma^*(x) \cdot S(x)$, which is obtained by a multiplication of an error location polynomial $\sigma^*(x)$ and the syndrome polynomial $S(x)$, where $\sigma^*(x)$ is the error location polynomial formed by values corresponding to error locations indicated by the pointers.

*Fig. 8*

EP 0 296 828 A2

# BACKGROUND OF THE INVENTION

## Field of the Invention

This invention relates generally to a method and apparatus for decoding Reed-Solomon Code and, more particularly, to a method and apparatus for decoding Reed-Solomon Code and performing error erasure correction.

## Description of the Background

Generally, it is shown to decode Reed-Solomon Code by using the steps of; i) calculation of the error syndromes; ii) derivation of an error location polynomial $\sigma$ (x) and an error evaluation polynomial $\omega$(x); iii) assumption of error locations and error values; and iv) execution of the error correction.

A decoding method using a solution that utilizes a root of a conventional equation cannot be applied to the situation for correcting multiple errors equal to or greater in number than five. In the case of correcting errors equal to or greater in number than give, a method using an Euclidean algorithm is known. That is, the production of the error location polynomial $\sigma$(x) and the error evaluation polynomial $\omega$ (x) is performed.

In the actual error correction, if values $(1, \alpha^{-1}, \alpha^{-2}, ...)$ are put into the error location polynomial $\sigma$(x) in that order and the value at that time becomes zero, it is assumed to be error location p. Also, the error pattern $e_p$ is obtained by:

$$e_p = \omega(\alpha^{-p}) \cdot (\sigma'(\alpha^{-p}))$$

where $\omega(\alpha^{-p})$ is obtained by putting $\alpha^{-p}$ into the error evaluation polynomial $\omega$(x) and $\sigma'(\alpha^{-p})$ is obtained by putting $\alpha^{-p}$ into a formal first-order differential polynomial $\sigma'$(x) of $\sigma$(x). However, to calculate $\sigma(\alpha^i)$ and $\sigma'(\alpha^i)$ separately requires a lot of time and also results in an increase in circuitry.

On the other hand, another error correction method called the erasure correction method is also known that is different than the error correction method mentioned above and in which an error location is obtained by using the error correction code itself and then the error is corrected. In the erasure correction method, a pointer is set at the error location that has been determined by using an error detection code or other means and an error at the error location indicated by the pointer is corrected using the error correction code.

Nevertheless, there is a problem in that it is impossible to judge whether the pointer indicates all error positions correctly or not. Thus, there is the real possibility that erroneous error correction may mistakenly occur in those cases where the pointer itself is incorrect.

# OBJECTS AND SUMMARY OF THE INVENTION

Accordingly, it is an object of the present invention to provide a method and apparatus for decoding Reed-Solomon Code that can eliminate the above-noted defects inherent in the prior art.

Another object of the present invention is to provide a method and apparatus for decoding Reed-Solomon Code that is capable of reducing the processing time and that can be realized by relatively simple circuitry.

A further object of the present invention is to provide a method and apparatus for decoding Reed-Solomon Code that is capable of checking whether the flags or pointers indicate error positions correctly and for performing erasure correction, by which operation the errors are eliminated, with high reliability.

According to an aspect of the present invention, in a decoding apparatus for the Reed-Solomon Code in which syndromes are calculated by a parity check matrix and the received data, an error location polynomial $\sigma$ (x) and an error evaluation polynomial $\omega$(x) are calculated, an error pattern $e_p$ is obtained by a calculation of $[e_p = \omega(\alpha^{-p})/\sigma'(\alpha^{-p})]$ using a formal first-order differential polynomial $\sigma'$(x) of said error location polynomial $\sigma$(x) and said error evaluation polynomial $\omega$(x), so that a symbol at an error location p is corrected. More specifically, the even-numbered terms $\sigma_e$(x) and the odd-numbered terms $\sigma_o$(x) of said error location polynomial are separated. Then $[\sigma_e(\alpha^{-m})]$ and $[\sigma_o(\alpha^{-m})]$, which are values obtained when predetermined values are put into each x of the separated even-numbered terms $\sigma_e(x)$ and odd numbered terms $\sigma_o(x)$, and then:

$$\sigma(\alpha^{-m}) = \sigma_e(\alpha^{-m}) + \alpha^{-m} \sigma_\bullet{}'(\alpha^{-m})$$
$$\sigma'(\alpha^{-m}) = \sigma_o{}'(\alpha^{-m})$$

are calculated so that $\sigma(\alpha^{-m})$ and $\sigma'(\alpha^{-m})$, are produced simultaneously. According to the present invention, a decoding method of a Reed-Solomon Code for calculating syndromes based on a parity check matrix and a received word, provides the steps of calculating an error location polynomial $\sigma(x)$ and an error evaluation polynomial $\omega(x)$ from the syndromes, obtaining an error pattern $e_p$ by a calculation of $[e_p = \omega(\alpha^{-p})\sigma'(\alpha^{-p})]$ by the use of a formal first-degree differential polynomial $\sigma'(x)$ of the error location polynomial $\sigma(x)$ and the error evaluation polynomial $\omega(x)$, and correcting symbols at an error location p.

Erasure correction is made by regarding pointers (flags) as correct when the condition:

deg $\sigma^*(x)$ > deg $\omega^*(x)$

is established, on the assumption that $\sigma^*(x) \cdot S(x)$, which is obtained by a multiplication of an error location polynomial $\sigma^*(x)$ and a syndrome polynomial $S(x)$, where $\sigma^*(x)$ is the error location polynomial formed by values corresponding to error locations indicated by the pointers. As a result, the reliability of the pointers can be checked with certainty.

The above and other objects, features, and advantages of the present invention will become apparent from the following detailed description of preferred embodiments thereof to be read in conjunction with the accompanying drawings.


## BRIEF DESCRIPTION OF THE DRAWINGS


Figs. 1A and 1B are respective schematic representations of data words and error location polynomials useful for describing decoding of Reed-Solomon Code;

Figs. 2A and 2B are respective schematic representations of data words including errors and an error pattern useful in describing decoding of Reed-Solomon Code;

Figs. 3A, 3B, and 3C are respective schematic representations of data words including errors, an error pattern, and error pointers useful in describing decoding of Reed-Solomon code;

Fig. 4A, 4B, and 4C are respective schematic representations of data words including errors, an error pattern, and error pointers useful in describing decoding of Reed-Solomon code;

Figs. 5A, 5B, and 5C are respective schematic representations of data words including errors, an error pattern, and error pointers useful in describing decoding of Reed-Solomon code;

Fig. 6 is a schematic in block diagram form of a part of a decoder for Reed-Solomon Code according to one embodiment of the present invention;

Figs. 7A and 7B are timing charts showing the operation of the decoder for Reed-Solomon Code shown in Fig. 6;

Fig. 8 is a flow chart showing a method for decoding Reed-Solomon Code according to one embodiment of the present invention;

Fig. 9 is a schematic in block diagram form of an embodiment of a polynomial multiplier;

Figs. 10A and 10B are schematics in block diagram form useful in describing the embodiment of Fig. 9;

Fig. 11 is a schematic in block diagram form of embodiment of a polynomial multiplier;

Figs. 12A, 12B, and 12C are schematics in block diagram form useful in describing the embodiment of Fig. 11;

Fig. 13 is a schematic in block diagram form of an embodiment of a calculation circuit for calculating $\sigma^*(x) S(x)$; and

Fig. 14 is a schematic block diagram form of another embodiment of a calculation circuit for calculating $\sigma^*(x) S(x)$.

## DETAILED DESCRIPTION OF THE PREFERRED EMBODIMENTS

Before describing an embodiment of the present invention, a conventional decoding method of Reed-Solomon code using the Euclidean algorithm will be described.

If it is assumed that t is the number of correctable symbols and n is the code length, then a parity check matrix H for correction of t errors of Reed-Solomon code will be expressed by:

$$H = \begin{bmatrix} 1 & \alpha & \alpha^2 & \alpha^3 \cdots\cdots & \alpha^{n-1} \\ 1 & \alpha^2 & \alpha^4 & \alpha^6 \cdots\cdots & \alpha^{2(n-1)} \\ \cdot & & \cdot & & \cdot \\ \cdot & & \cdot & & \cdot \\ \cdot & & \cdot & & \cdot \\ 1 & \alpha^{2t} & (\alpha^2)^{2t} & (\alpha^3)^{2t} \cdots & (\alpha^{n-1})^{2t} \end{bmatrix}$$

From the product of the foregoing parity check matrix H and the received signal, the syndromes are generated and the following syndrome polynomials are defined:

$$S_0 = \sum_{i=1}^{n} r_i \, \alpha^{i-1} = \sum_{k \in E} e_k \, \alpha^{(k-1)}$$

$$S_1 = \sum_{i=1}^{n} r_i \, \alpha^{2(i-1)} = \sum_{k \in E} e_k \, \alpha^{2(k-1)}$$

$$\cdot$$
$$\cdot$$
$$\cdot$$

$$S_j = \sum_{i=1}^{n} r_i \, \alpha^{(j+1)(u-1)} = \sum_{k \in E} e_k \, \alpha^{(j+1)(k-1)}$$

$$\cdot$$
$$\cdot$$
$$\cdot$$

$$S_{2t-1} = \sum_{i=1}^{n} r_i \, \alpha^{2t(i-1)} = \sum_{k \in E} e_k \, \alpha^{2t(k-1)}$$

The following polynomial, in which the values generated in the above equations are used as coefficients, is referred to as a syndrome polynomial.

$$S(x) = S_0 + S_1 x + S_2 x^2 + \ldots + S_{2t-1} x^{2t-1}$$

There are various kinds of polynomials known for error correction, and they all satisfy the following relation:

$$\phi(x) \cdot x^{2t} + \sigma(x) \cdot S(x) = \omega(x)$$

where.

$$S(x) = \sum_{i=0}^{2t-1} S_i \, x^i \qquad : \text{syndrome polynomial,}$$

$$\sigma(x) = \prod_{L \in E} (x - \alpha^{-(L-1)}) \qquad : \text{error position polynomial,}$$

$$\omega(x) = \sum_{L \in E} e_L \cdot \prod_{\substack{K \in E \\ K \neq L}} (x - \alpha^{-(k-1)}) \qquad : \text{error evaluation polynomial,}$$

$$\phi(x) = \sum_{L \in E} e_L \cdot \alpha^{2t(L-1)} \cdot \prod_{\substack{K \in E \\ K \neq L}} (x - \alpha^{-(k-1)})$$

Among the above equations, the error location polynomial $\sigma(x)$ and the error evaluation polynomial $\omega(x)$ are required when the error correction is actually performed.

Assuming that the above equations are always satisfied, $x^{2t}$ is obviously known, and $S(x)$ can be known from the received signal. From $x^{2t}$ and $S(x)$, $\sigma(x)$ and $\omega(x)$ can be obtained by using the Euclidean algorithm. In a well-known example, the Euclidean algorithm is used to solve a problem such as: "For given positive integers m and n, calculate the greatest common measure d and integers a and b that satisfy the expression (am + bn = d)". The Euclidean algorithm is also similarly used in the case of polynomials, in addition to being used simply with integers as in the above. More specifically, it is sufficient to derive a correspondence such that $(m \rightarrow x^{2t})$ and $(n \rightarrow S(x))$. Nevertheless, in the above example involving integers, the greatest common measure d is obtained by executing the Euclidean algorithm to its final stage. Similarly, in the case of obtaining $\sigma(x)$ and $\omega(x)$ to execute the error correction, the greatest common measure is not obtained until the final stage of the algorithm is executed, however, if the following conditions are satisfied during the algorithm, the execution of the algorithm can be stopped.

$t \geqq \deg \sigma(x) > \deg \omega(x)$

(deg means the number of the order of a polynomial).

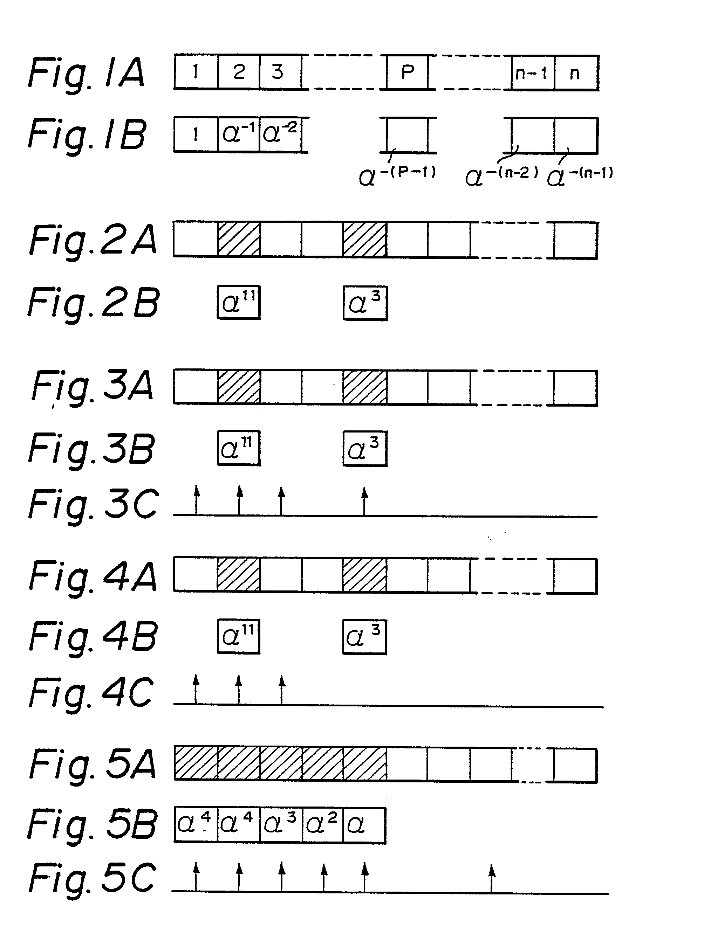

The assumption of error positions and error values can be done using $\sigma(x)$ and $\omega(x)$ derived by using the Euclidean algorithm, and error correction is performed. This processing will be explained using the example of a four-sample error correction code. When a received signal consists of n symbols, as represented in Fig. 1A, the values that are substituted as x in the error position polynomial $\sigma(x)$, are $(1, \alpha^{-1}, \alpha^{-2}, \ldots \alpha^{-(p-1)}, \ldots, \alpha^{-(n-1)})$ from the end of the received signal to the beginning thereof, in the order as shown in Fig. 1B. Namely, the number of P is the number that is counted from the end of the received signal.

As one example, assuming that the end of the signal is the 0th position, errors occur at the first and fourth positions, respectively, as indicated by the shaded portions in Fig. 2A. Now error correction will be considered in the case where these errors are an error pattern of $(\alpha^{11}, \alpha^3)$, as shown in Fig. 2B. A syndrome polynomial in this case will be:

$S(x) = \alpha^3 x^7 + \alpha^9 x^6 + \alpha^7 x^5 + \alpha^{10} x^4 + \alpha x^3 + \alpha^3 x^2 + \alpha^4 x + \alpha^2$

$\sigma(x)$ and $\omega(x)$ are obtained by the Euclidean algorithm using the syndrome polynomial $S(x)$ and $x^{2.4}$. As a result, the error location polynomial $\sigma(x)$ and the error evaluation polynomial $\omega(x)$ can be obtained as follows.

$\sigma(x) = x^2 + \alpha^{10} x + \alpha^{10}$

$\omega(x) = \alpha^5 x + \alpha^{12}$

Thus, $\sigma'(x)$, which is obtained by a formal first-order differential of $\sigma(x)$, becomes:

$\sigma'(x) = \alpha^{10}$

Error locations and error patterns are obtained using the error location polynomial and the error evaluation polynomial. If values $(1, \alpha^{-1}, \alpha^{-2}, \ldots)$ are put into the error location polynomial $\sigma(x)$ in that order and the value at that time becomes zero, it is assumed to be an error position.

5

Also, an error pattern $e_p$ is obtained by $e_p = \omega(\alpha^{-p}) / \sigma'(\alpha^{-p})$.

In the example of Fig. 2A,
$$\sigma(\alpha^{-1}) = \alpha^{-2} + \alpha^3 + \alpha^{10} = 0$$
$$\sigma(\alpha^{-4}) = \alpha^{-8} + \alpha^6 + \alpha^{10} = 0$$
are established so that an error location can be detected. Error patterns $e_1$ and $e_4$ assume the values:
$$e_1 = \omega(\alpha^{-1}) / \alpha^{10} = \alpha^6 / \alpha^{10} = \alpha^{-4} = \alpha^{11}$$
$$e_4 = \omega(\alpha^{-4}) / \alpha^{10} = \alpha^{12} / \alpha^{10} = \alpha^3$$

As a result, correct error patterns can be obtained. The execution of the error correction can be obtained by performing the addition (mod. 2) of the error patterns and a received sequence.

In regard to the above-described Reed-Solomon Code, one error contains two unknowns. Therefore, in the case of t-multiple error correction, 2t parities are added, and in the case where 2t syndromes, generated on the receiving side, contain t errors, it is possible to solve t error positions and t error patterns corresponding to 2t independent equations.

In addition to the error correction method described above there is also the so-called erasure correction method for decoding the Reed-Solomon Code.

In such method, the above-described equation will be taken up again and:
$$\phi(x) \cdot x^{2t} + \sigma(x) \cdot S(x) = \omega(x)$$
As a result,
$$\sigma(x) \cdot S(x) \equiv \omega(x) \ (\text{mod. } x^{2t})$$
is established. A calculation can be made with respect to the example of Figs. 2A and 2B such that:
$$S(x) = \alpha^8 x^7 + \alpha^9 x^6 + \alpha^7 x^5 + \alpha^{10} x^4 + \alpha x^3 + \alpha^3 x^2 + \alpha^4 x + \alpha^2$$
$$\sigma(x) = x^2 + \alpha^{10} x + \alpha^{10}$$
$$\sigma(x) S(x) = \alpha^8 x^9 + \alpha x^8 + \alpha^5 x + \alpha^{12} \equiv \alpha^5 x + \alpha^{12} \ (\text{mod. } x^8) = \omega(x)$$
Thus, it can be seen that the above equations are established.

In the case of erasure correction, pointers are generated using another error detection code, and the pointers indicate that errors are likely to exist. Therefore, it should be noted that the symbol is not always an error even if a pointer is set. As shown in Figs. 3A and 3B errors similar to those represented in Fig. 2B occur, and erasure correction will be explained for the case where pointers are set at the position shown in Fig. 3C.

First, an error location polynomial $\sigma^*1$ corresponding to the error position polynomial $\sigma(x)$ is synthesized using the errors pointed out by the pointer. Because the pointers are set at the positions corresponding to $(x = 1) (x = \alpha^{-1}) (x = \alpha^{-2}) (x = \alpha^{-4})$ as indicated in Fig. 3C, $\sigma_1^*(x)$ is obtained as follows:
$$\sigma_1^*(x) = (x + 1)(x + \alpha^{-1})(x + \alpha^{-2})(x + \alpha^{-4}) = x^4 + \alpha^7 x^3 + \alpha^3 x^2 + \alpha^{10} x + \alpha^8$$

An error evaluation polynomial $\omega^*(x)$ is obtained using this error location polynomial $\sigma_1^*(x)$ and the syndrome polynomial $S(x)$.
$$\sigma_1^*(x) \cdot S(x) \equiv \omega_1^*(x)$$
With an actual calculation,
$$\omega_1^*(x) = \alpha^5 x^3 + x^2 + \alpha^{10} \ (\text{mod. } x^8)$$
Moreover,
$$\sigma_1^{*'}(x) = \alpha^7 x^2 + \alpha^{10}$$
As a result, when error patterns are obtained, the following is established:
$$x = 1$$
$$e_0 = \omega_1^*(1) / \sigma_1^{*'}(1) = 0/\alpha^6 = 0$$
Since this is not the place where an error occurs, the error pattern may be zero.
$$x = \alpha^{-1}$$
$$e_1 = \omega_1^*(\alpha^{-1}) / \sigma_1^{*'}(\alpha^{-1}) = \alpha^{11}/1 = \alpha^{11}$$
$$x = \alpha^{-2}$$
$$e_2 = \omega_1^*(\alpha^{-2}) / \sigma_1^{*'}(\alpha^{-2}) = 0/\alpha^{12} = 0$$
$$x = \alpha^{-4}$$
$$e_4 = \omega_1^*(\alpha^{-4}) / \sigma_1^{*'}(\alpha^{-4}) = \alpha^{14} / \alpha^{11} = \alpha^3$$

As has been described before, it is understood that all error patterns are obtained and corrected accurately.

In the erasure correction method, there is the possibility that erroneous correction may happen in the case where a pointer is incorrect. For example, when errors similar to those shown in Figs. 3A, 3B and 4A, 4B are generated, the case where a pointer erroneously overlooks an error is shown in Fig. 4C and will be explained as follows.

An error location polynomial $\sigma_2^*(x)$ obtained by this pointer is:
$$\sigma_2^*(x) = (x + 1)(x + \alpha^{-1})(x + \alpha^{-2}) = x^3 + \alpha^8 x^2 + \alpha^3 x^2 + \alpha^7 x + \alpha^{12}$$

6

Further, by calculating $\sigma_2^*(x) \cdot S(x)$,

$\sigma_2^*(x) S(x) \equiv \alpha x^7 + \alpha^{12}x^6 + \alpha^8 x^5 + \alpha^4 x^4 + \alpha^3 + \alpha^3 x^2 + \alpha^{14} = \omega_2^*(x)$ (mod. $x^8$)

is proved. Thus, with this polynomial error correction for a position that is not indicated by a pointer cannot be performed. Accordingly, it is a purpose of this present invention to provide an approach to overcoming the drawback.

As mentioned above, in actual error correction, $\sigma(\alpha^i)$, $\omega(\alpha^i)$ and $\sigma'(\alpha^i)$ must be calculated when $(x = \alpha^i)$ is given. In this case, to calculate $\sigma(\alpha^i)$ and $\sigma'(\alpha^i)$ separately requires a lot of time, resulting in an increase in circuitry. An object of the present invention is therefore to provide a decoding apparatus for the Reed-Solomon Code that is capable of calculating $\sigma(\alpha^i)$ and $\sigma'(\alpha^i)$ simultaneously at the time of error correction, of reducing the processing time, and of simplifying the circuitry.

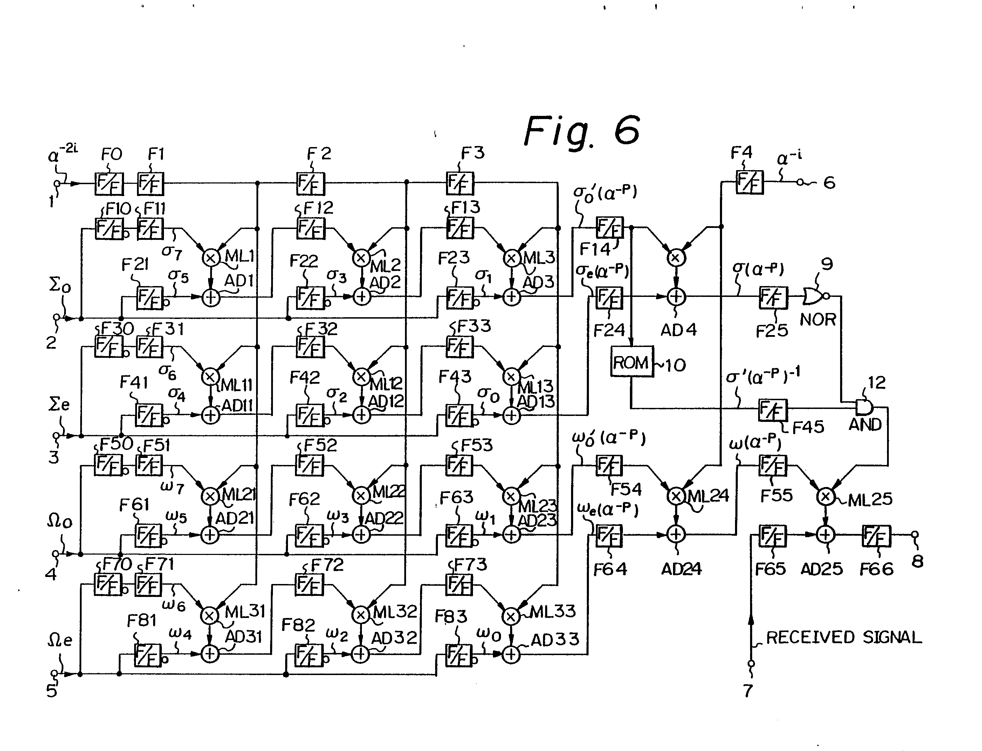

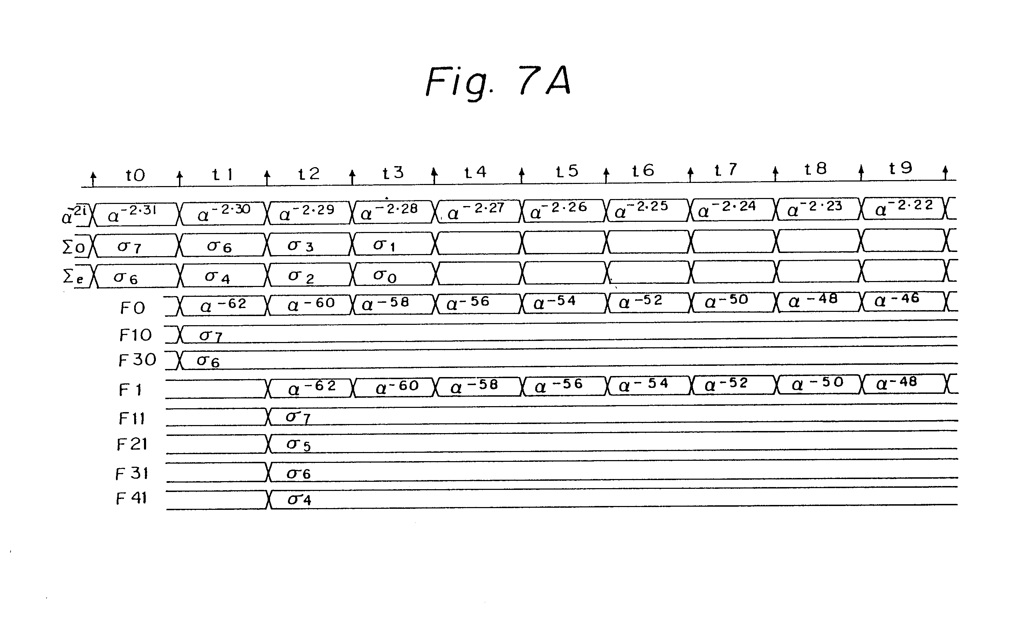

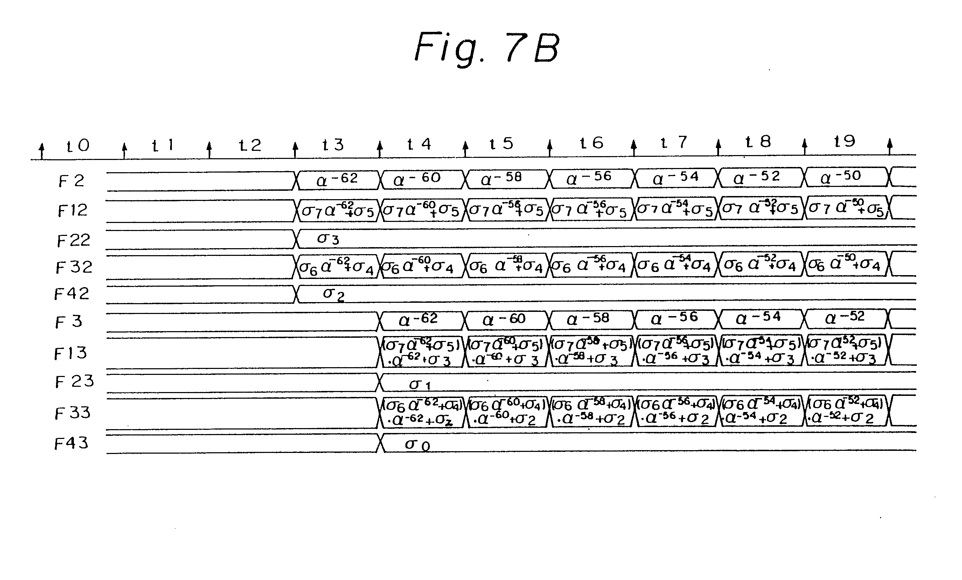

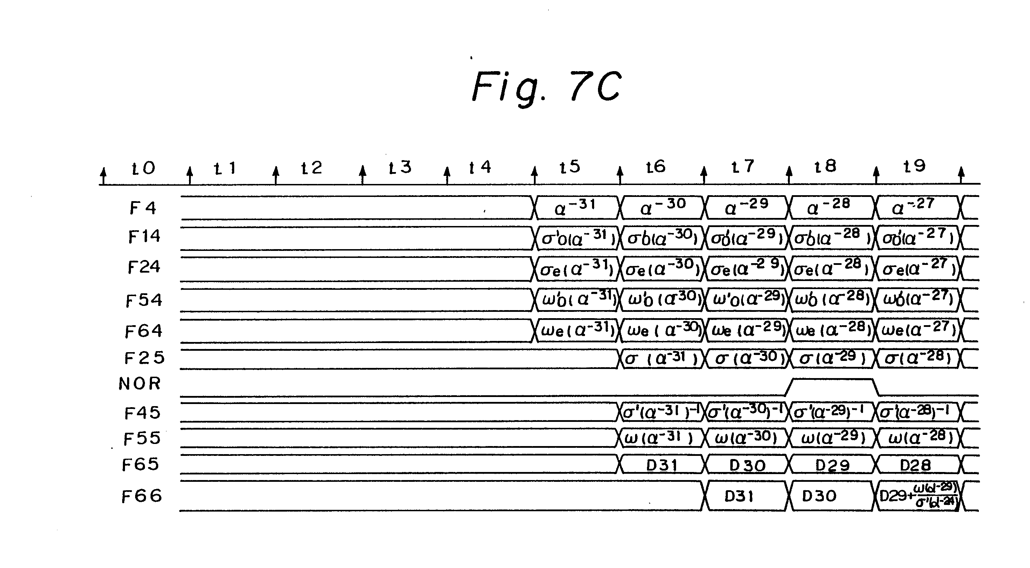

Fig. 6 shows a circuit arrangement of one embodiment of the present invention and Fig. 7 is a timing chart useful in describing the circuit operation of Fig. 6.

In Fig. 6, values of $\alpha^{-2i}$ are sequentially supplied to an input terminal 1 and, more specifically, assuming that a code length is n, $(\alpha^{-2(n-1)}, \alpha^{-2(n-2)}, \alpha^{-2(n-3)} \ldots \alpha^{-2}, \alpha^0)$ are sequentially fed to input terminal 1. As will be seen from the timing chart of Fig. 7A, (n = 32) is established.

In Fig. 6, a sequence $(\sigma_7, \sigma_5, \sigma_3, \sigma_1)$ of odd number terms $\Sigma_0$ of an error location polynomial $\sigma(x)$ are sequentially supplied to another input terminal 2, and a sequence $(\sigma_6, \sigma_4, \sigma_2, \sigma_0)$ of even number terms $\Sigma_e$ of the error position polynomial $\sigma(x)$ are sequentially fed to another input terminal 3. A sequence of odd number terms $\Omega_0$ of an error evaluation polynomial $\omega(x)$ are sequentially fed to input terminal 5, and a sequence of even number terms $\Omega_e$ of the error evaluation polynomial $\omega(x)$ are sequentially supplied to input terminal 6. The circuit of Fig. 6 performs a calculation on both $\sigma(x)$ and $\omega(x)$, and Figs. 7A and 7B show the timing chart of a calculation operation of $\sigma(x)$.

In Fig. 6, a prefix F indicates a D-type flip-flop and a D-type flip-flop with a clock enabling terminal, a symbol ML represents a multiplier of a finite field, and a symbol AD indicates an adder of a finite field.

As shown in Fig. 7A values of $\alpha^{-2i}$ having one clock delay in timing with one another are generated at respective outputs of D-type flip flops F0, F1, F2, and F3. Moreover values of $\sigma_7$ and $\sigma_6$ are subjected to sampling by each of flip-flops F10 and F30 that include a clock enabling terminal at the first stage.

$\sigma_7$ produced by a flip-flop F11 and $\alpha^{-2i}$ are multiplied in multiplier ML1, and the output signal of multiplier ML1 and that of a flip-flop F21 are added at an adder AD1. The output signal of adder AD1 is taken out through a flip-flop F12.

Similarly, $\sigma_6$ produced by a flip-flop 31 and $\alpha^{-2i}$ are multiplied in a multiplier ML11. The output signal of multiplier ML11 and that of a flip-flop F41 are added at an adder AD11, and the output signal of the adder AD11 is fed out through a flip-flop F32.

Calculations similar to those described above are done with respect to the odd number terms and the even number terms. As a result, data, which is taken into flip-flop F14, becomes $\sigma_o'(\alpha^{-p})$ and data which is taken into a flip-flop F24, becomes $\sigma_e'(\alpha^{-p})$. The output of the flip-flop F14 and $\alpha^{-1}$ fed through flip-flop F4 are multiplied at a multiplier ML4, and the output of multiplier ML4 and that of the flip-flop F24 are added in an adder AD4.

As a result, data, which is obtained by sequentially putting $\alpha^{-i}$ into x of the error location polynomial $\sigma(x)$, is produced at the output of adder AD4.

The output of adder AD4 is supplied to a NOR gate through a flip-flop F25. NOR gate 9 generates a high-level output when the output of the flip-flop F25 is zero, that is, at an error position.

Further, the output signal of the flip-flop F14 is fed to a ROM 10. ROM 10 produces $\sigma_o'(\alpha^{-p})^{-1}$, which is the inversion of $\sigma_o'(\alpha^{-p})$. The output of ROM 10 fed through a flip-flop F45 is supplied to an AND gate 12 together with that of NOR gate 90. The output of AND gate 12 is fed to a multiplier ML25.

Processing similar to that of error location polynomial $\sigma(x)$ is made with respect to the error evaluation polynomial $\omega(x)$, and $\omega_0(\alpha^{-p})$ is fed into a flip-flop F54 and $\omega_e(\alpha^{-p})$ is fed into a flip-flop F64. $\omega(\alpha^{-p})$ is fed into a flip-flop F55 as the output of a multiplier ML24 fed through an adder A24. The output of the flip-flop F55 and $\sigma'(\alpha^{-p})$, which is the output of AND gate 12, are multiplied at the multiplier ML25.

An error pattern indicated by $[e_p = \omega(\alpha^{-p}) / \sigma'(\alpha^{-p})]$ is obtained at the output of the multiplier ML25. The error pattern is supplied to an adder AD25 and added to the received signal fed in at terminal 7 after it has passed through a flip-flop F65. As a result, error correction is executed. The output signal of the adder AD25 therefore becomes post-correction data, and the post-correction data is taken out at an output terminal 8 through a flip-flop F66.

Given an error position polynomial $\sigma(x)$, by

$\sigma(x) = \sigma_0 + \sigma_1 x + \sigma_2 x^2 + \sigma_3 x^3 + \sigma_4 x^4$ , the calculation of $\sigma(\alpha^{-i})$ and $\sigma'(\alpha^{-i})$ is done. At this time,

The following separation is made:

$\sigma(x) = \sigma_e(x) + \sigma_0(x)$

where $\sigma_e(x)$ is an even number term and $\sigma_o(x)$ is an odd number term. In this case since $(\sigma'(x) = \sigma_o'(x))$ and $(\sigma_o(x) = x \cdot \sigma'_o(x))$ are established,

$$\sigma(x) = \sigma_e(x) + x \cdot \sigma'(x) = \sigma_e(x) + x \cdot \sigma'_o(x)$$

can be written. As a result, when $\sigma(\alpha^{-i})$ is calculated,

$$\sigma(\alpha^{-i}) = \sigma_e(\alpha^{-i}) + \alpha^{-i}\sigma'_o(\alpha^{-i})$$
$$\sigma'(\alpha^{-i}) = \sigma'_o(\alpha^{-i})$$

can be calculated by the separate calculation of $\sigma_e(\alpha^{-i})$ and $\sigma'_e(\alpha^{-i}$. As a result, the simultaneous calculation of $\sigma(\alpha^{-i})$ and $\sigma'_o(\alpha^{-i})$ can be attained. The calculation of the error evaluation polynomial $\omega(x)$ can be done in a quite similar way, since its order is one less than $\sigma(w)$.

According to the present invention, no separate calculation of $\sigma(\alpha^{-m})$ and $\sigma'(\alpha^{-m})$ is needed with respect to the error location polynomial $\sigma(x)$. Therefore, a reduction of the processing time can be achieved. Also, the circuit size can be reduced. Further, because the calculation of the error evaluation polynomial $\omega(x)$ is done in a similar manner, the common control of $\sigma(x)$ and $\omega(x)$ can be made at the time of the above-mentioned calculation.

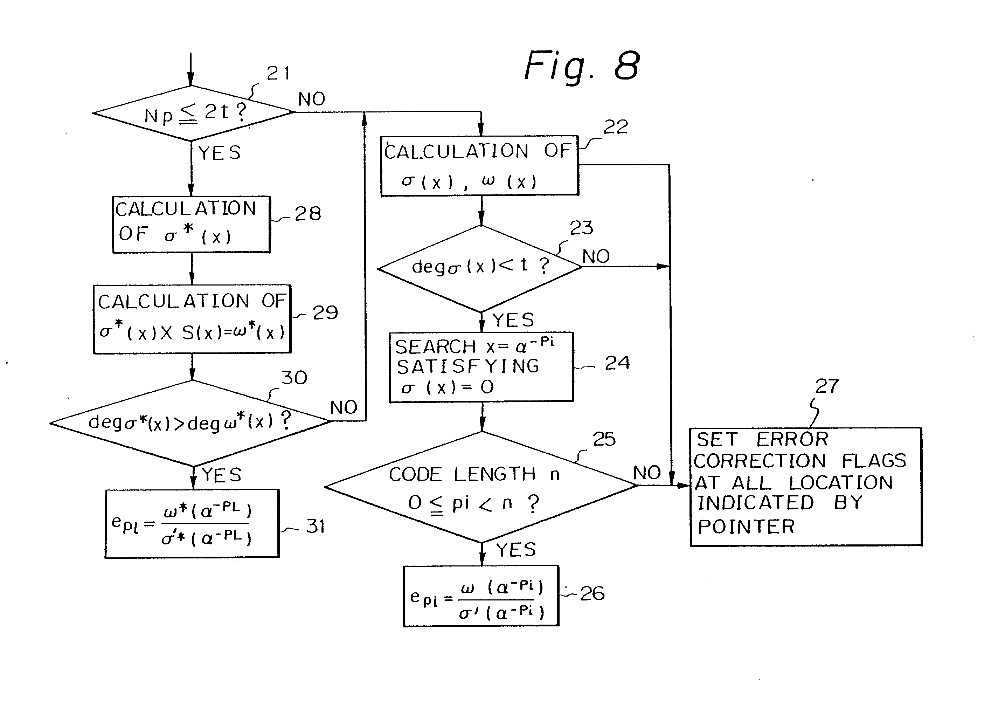

Another embodiment of the present invention is described in relation to Fig. 8, which is a flow chart showing a decoding method of the Reed-Solomon Code. In Fig. 8, it is first checked in step 21 whether the number of pointers $N_p$ is equal to or less than 2t. If the number of pointers $N_p$ is not equal to or less than 2t, processing goes to step 22, because error correction can be performed without using the pointers. An error location polynomial $\sigma(x)$ and an error evaluation polynomial $\omega(x)$ can be obtained from a syndrome polynomial $S(x)$ and for this operation the Euclidean algorithm may be employed.

From step 22 the process moves to step 23 to examine whether (deg $\sigma(x) < t$) is established. If this condition is not established, error correction flags are set at all the pointer positions at step 27, because error correction becomes impossible. When the condition of step 23 is satisfied, processing goes to step 24 to detect an error position. That is, $(x = \alpha^{-pi})$, which is ($\sigma(x) = 0$), is detected and the detected error position pi is subjected to checking whether $(0 \le Pi < n)$ is established at step 25. When the condition of step 25 is met, processing moves to step 26 for error correction. On the other hand, when the condition of step 25 is not satisfied, processing goes to step 27 for setting the error correction flags.

Error correction is processed by obtaining an error pattern by the following equation where $\sigma'(x)$ is a formal first-order differential of the error location polynomial $\sigma(x)$ and by adding the error pattern to a word of the received signal.

$$e_{pi} = \omega(\alpha^{-pi}) \cdot \sigma'(\alpha^{-pi})$$

When the number of the error pointers $N_p$ is equal to or larger than 2t as determined in step 21, erasure correction , which is different from the above-mentioned processing, is subsequently performed. In the case of erasure correction, the error location polynomial $\sigma^*(x)$ is calculated from the pointer positions in step 28 and in the next step 29 $\omega^*(x)$ $(= \sigma^*(x) \cdot S(x))$ is calculated.

Here, a judgement of the reliability of the pointers is made in step 30 so that when (deg $\sigma^*(x) >$ deg $\omega^*(x)$) is established, it is judged that the reliability of the pointers is high, and an error pattern $e_{pL}$ is obtained at step 31 as follows:

$$e_{pL} = \omega^*(\alpha^{-pL} / \sigma^{*'}(\alpha^{-pL}))$$

When the reliability of the pointers is low, no erasure correction is made, as represented at the NO decision in step 30.

For example, in the case where errors occur at positions $(1, \alpha^{-1}, \alpha^{-2}, \alpha^{-3}, \alpha^{-4})$ as indicated by the shade lines in Fig. 5A, respective errors are $(\alpha^4, \alpha^4, \alpha^3, \alpha^2, \alpha)$, as shown at Fig. 5B, and pointers are set at positions $(1, \alpha^{-1}, \alpha^{-2}, \alpha^{-3}, \alpha^{-4}, \alpha^{-7})$, as shown in Fig. 5C.

By use of these pointers, an error position polynomial $\sigma^*_3$ as follows is obtained.

$$\sigma^*_3(x) = (x + 1)(x + \alpha^{-1})(x + \alpha^{-2})(x + \alpha^{-3})(x + \alpha^{-4})(x + \alpha^{-7}) = x^6 + x^5 + \alpha^6 x^4 + \alpha^{10} x^3 + \alpha^4 x^2 + \alpha^8 x + \alpha^{13}$$

As a result,

$$\sigma^*_3 = x^4 + \sigma^{10} x^2 + \sigma^3$$

A syndrome polynomial $S(x)$ derived from a received signal is:

$$S(x) = \alpha^{14} x^7 + \alpha^8 x^6 + \alpha^2 x^5 + \alpha^6 x^4 + \alpha^8 x^3 + x^2 + \alpha^7 x + \alpha^4$$

An error evaluation polynomial $\omega^*_3(x)$ becomes

$$\sigma^*_3(x) \cdot S(x) \equiv \alpha^{11} x^5 + x^4 + \alpha^{11} x^3 + \alpha^{14} x^2 + \alpha^{14} x + \alpha^2 = \omega^*_3(x) \ (\text{mod. } x^8)$$

Also,

$$\deg \sigma^*_3(x) = \deg \omega^*_3(x) + 1$$

is established. As a result, it can be understood that the pointers contain true error positions. In other words, it can be said that the pointers are reliable. Actually, when error patterns are obtained by $\sigma^*_3(x)$ and $\omega^*_3(x)$, the following is established:

$$x = 1$$

$$e_0 = \omega_3^* (1) / \sigma_3^* \qquad\qquad (1)$$
$$= \alpha^8 / \alpha^4 = \alpha^4$$

$$x = \alpha^{-1}$$

$$e_1 = \omega_3^* (\alpha^{-1}) / \sigma_3^* (\alpha^{-1})$$
$$= 1 / \alpha^{11} = \alpha^4$$

$$x = \alpha^{-2}$$

$$e_2 = \omega_3^* (\alpha^{-2}) / \sigma_3^{*\,\prime} (\alpha^{-2})$$
$$= \alpha^4 / \alpha = \alpha^3$$

$$x = \alpha^{-3}$$

$$e_3 = \omega_3^* (\alpha^{-3}) / \sigma_3^{*\,\prime} (\alpha^{-3})$$
$$= \alpha^{13} / \alpha^{11} = \alpha^2$$

$$x = \alpha^{-4}$$

$$e_4 = \omega_3^* (\alpha^{-4}) / \sigma_3^{*\,\prime} (\alpha^{-4})$$
$$= \alpha^4 / \alpha^3 = \alpha$$

$$x = \alpha^{-7}$$

$$e_7 = \omega_3^* (\alpha^{-7}) / \sigma_3^{*\,\prime} (\alpha^{-7})$$
$$= 0 / \alpha^{12} = 0$$

Since this position is not a true error, it is correct that the location should be zero.

In the above example of erasure correction, the following two kinds of calculations are required:

1. Coefficients $\sigma_j$ (j = 1, 2, ... 2t-1) of the error location polynomial $\sigma^*(x)$ using, as a root, $\alpha^{-Li}$ (i = 1, 2, ..., 2t) corresponding to pointer locations are obtained.

$$\sigma^* (x) = \prod_{i=1}^{2t} (x + \alpha^{-Li})$$

$$= \sum_{j=0}^{2t-1} \sigma_j x^j$$

2. The error evaluation polynomial $\omega^*(x)$ is obtained by multiplying the obtained $\sigma^*(x)$ and the syndrome polynomial S(x) obtained from syndromes of the received signal.

$$\omega^*(x) \equiv \sigma^*(x) \cdot S(x)$$

Further, as an important check, it is confirmed whether:

$$\deg\sigma^*(x) = \deg\omega^*(x) + 1$$

is established.

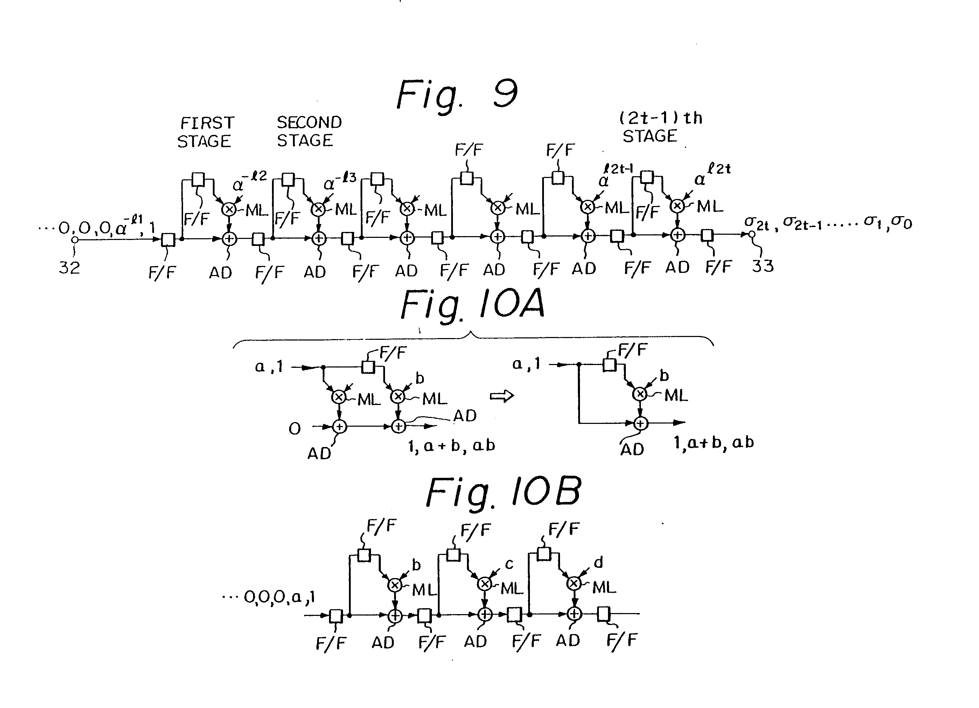

Fig. 9 is an embodiment of a calculation circuit for $\sigma^*(x)$, and in Fig. 9, a flip-flop (F/F) is used for producing a one clock delay, and is combined with an adder AD of a finite field and a multiplier ML of a finite field. Data is fed in at input terminal 32 in the order of $(1, \alpha^{-L1}, 0, 0, 0...)$. There are $(2t-1)$ stages in the calculation circuit of Fig. 9, whose unit structure is composed of two flip-flops (F/Fs), a multiplier M1 and an adder AD connected in cascade. In addition, $\alpha^{-L2}, \alpha^{-L3}... \alpha^{-L2t}$ are supplied to the multipliers ML of the respective stages. $\alpha_{2t}$ is obtained first at an output terminal 33, then $\sigma_{2t-1}' ... \sigma_1$ are obtained sequentially, and finally $\sigma_0$ is obtained.

The operation of the calculation circuit shown in Fig. 9 will be described referring to Figs. 10A and 10B, and the calculation of $(x + a)(x + b)(x + c)(x + d)$ will be considered. In Fig. 10A a circuit for outputting $(1, a + b, ab)$ is constructed using one flip-flop (F/F), two multipliers ML and two adders AD. As indicated in Fig. 10A, this circuit structure can be replaced with a simplified circuit consisting of one flip-flop F/F, an adder AD, and a multiplier ML.

Because Fig. 10A shows a circuit for performing the calculation of $(x + a)(x + b)$, a calculation circuit of $(x + a)(x + b)(x + c)(x + d)$ can be realized by the structure in which the result of the calculation is fed to a multiplier of $(x + c)$, as shown in Fig. 10B, and this result is then supplied to a multiplier of $(x + d)$. In this case, an input of $(1, a, 0, 0)$ is provided, and the coefficients for the answer are output in the order of descending power.

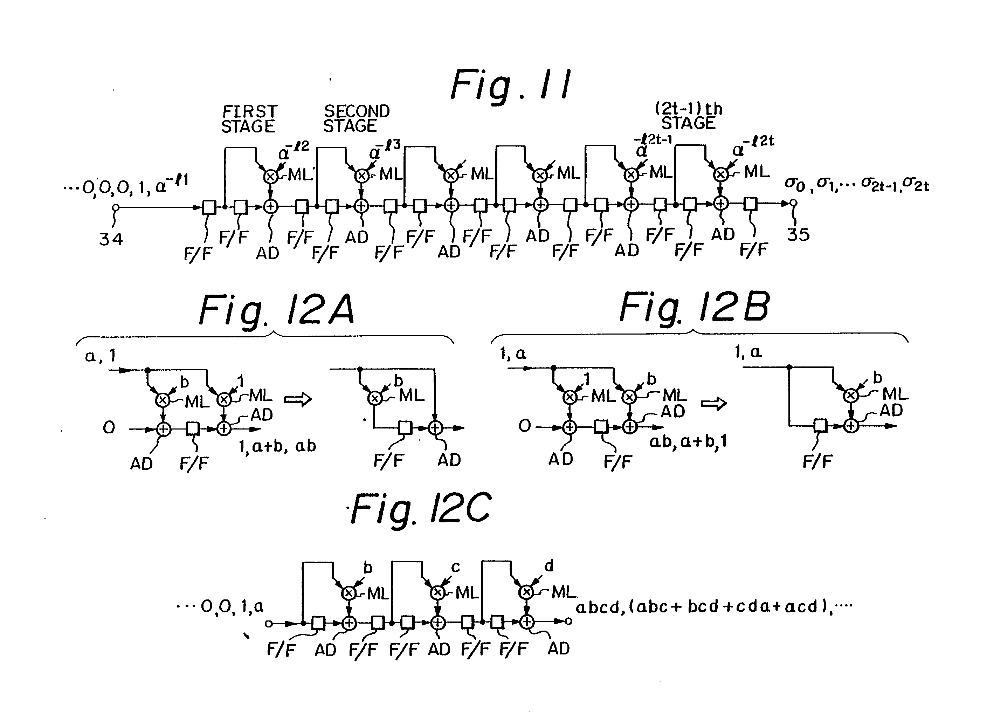

Fig. 11 is another embodiment of a calculation circuit of (x) to which data in the order to $(\alpha^{-L1}, 1, 0, 0, 0 ...)$ is fed in at input terminal 34.

There are $(2t-1)$ stages whose unit structure is made up of two flip-flops F/F, a multiplier ML, and an adder AD that are connected in cascade. In addition, inputs of $\alpha^{-L2}, \alpha^{-L3} .... \alpha^{-L2t}$ are fed to the multipliers ML of the respective stages. $\sigma_0$ is obtained first at the output terminal 35 then $\sigma_1, ... \sigma_{2t-1}$ are obtained sequentially, and finally $\sigma_{2t}$ is obtained.

The calculation circuit shown in Fig. 11 will be described with reference to Figs. 12A and 12C and the calculation of $(x + a)(x + b)(x + c)(x + d)$ will be considered. As indicated in Fig. 12A, a circuit for outputting $(1, a + b, ab)$ is constructed using one flip-flop F/F, two multipliers ML, and two adders AD and this circuit can be replaced by a simplified circuit consisting of one flip-flop F/F, one adder AD, and one multiplier ML. Because the circuit of Fig. 12A separates the multipliers ML and the adder AD, and the entire configuration does not look good, inputs a, 1 are replaced by 1, a, as shown in Fig. 12B.

Since Fig. 12B shows a circuit for performing the calculation of $(x + a)(x + b)$, a calculation circuit of $(x + a)(x + b)(x + c)(x + d)$ can be provided in which the result of the first calculation is fed to a multiplier $(x + c)$, as shown in Fig. 12C, and this result is then supplied to a multiplier of $(x + d)$. In this case, an input is $(a, 1, 0, 0, ...)$, and coefficients for response are output in the order of ascending power.

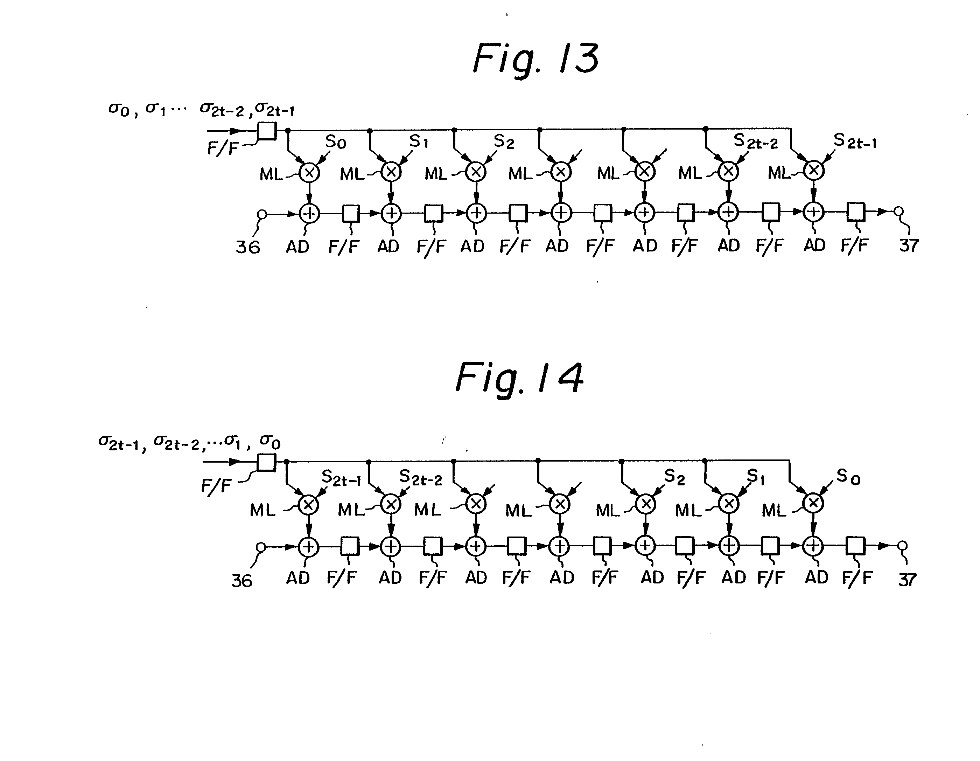

Figs. 13 and 14 are embodiments of a calculation circuit of $\omega^*(x)$ in which 0 is supplied to an input terminal 36. In the circuit of Fig. 13, an output is obtained at output terminal 37 in the order of descending power. On the other hand, an output is produced at output terminal 37 in the order of ascending power in the circuit of Fig. 14.

Although the above is based on data as shown in Fig. 5A, other examples using data shown in Figs. 3A and 4A could be calculated as well as. For example, as shown in Fig. 3C, if pointers containing all error positions are set,

$$\sigma_1^*(x) = (x + 1)(x + \alpha^{-1})(x + \alpha^{-2})(x + \alpha^{-4}) = x^4 + \alpha^7 x^3 + \alpha^3 x^2 + \alpha^{10} x + \alpha^8$$

$$\omega_1^*(x) = \alpha^5 x^3 + x^2 + \alpha^{10} \;(\text{mod. } x^8)$$

are established.

On the other hand, as in a pointer shown in Fig. 4C, if the pointer does not contain any error position, then:

$$\sigma_2^*(x) = (x + 1)(x + \alpha^{-1})(x + \alpha^{-2}) = x^3 + \alpha^8 x^2 + \alpha^3 x^2 + \alpha^7 x + \alpha^{12}$$

Further, by calculating $\sigma_2^*(x) \cdot S(x)$,

$$\sigma_2^*(x) S(x) \equiv \alpha x^7 + \alpha^{12} x^6 + \alpha^8 x^5 + \alpha^4 x^4 + x^3 + \alpha^3 x^2 + \alpha^{14} = \omega_2^*(x) \;(\text{mod. } x^8)$$

is established. From these, the following is understood:

In the case where erasure correction is made with a t-multiple correction code:

a. when pointers, which are equal to or less than 2t, contain all correction positions,

deg $\sigma^*(x) >$ deg $\omega^*(x)$

( or deg $\sigma^*(x) =$ deg $\omega^*(x) + 1$ )

b. when the pointers, which are equal to or less that 2t, do not contain any error position, that is, when they do not work as accurate pointers,

deg $\sigma^*(x) \leqq$ deg $\omega^*(x)$

is established.

Accordingly, the invention enables checking the reliability of the pointer at the time of erasure correction. Since this permits the detection of an error, stopping the erasure correction and checking whether normal error correction is possible even if an error is present in a pointer, increases the number of the cases where error correction can be made.

The above description is given on preferred embodiments of the invention, but it will be parent that many modifications and variation could be effected by one skill in the art without departing from the spirit or scope of the novel concepts of the invention, which should be determined by the appended claims.

**Claims**

1. A method for decoding Reed Solomon Code in which syndromes are calculated by a parity check matrix and a received word, an error location polynomial $\sigma(x)$ and an error evaluation polynomial $\omega(x)$ are calculated, an error pattern $e_p$ is obtained by a calculation of

$[e_p = \omega)\alpha^{-p}) \cdot \sigma'(\alpha^{-p})$ using a formal first-order differential polynomial $\sigma'(x)$ of the error location polynomial $\sigma(x)$ and the error evaluation polynomial $\omega(x)$, so that a symbol of the received word at an error position p is corrected,

the method comprising steps of:

separating even-numbered terms $\sigma_e(x)$ and odd numbered terms $\sigma_\bullet(x)$ of said error location polynomial $\sigma(x)$;

obtaining $[\sigma_0(\alpha^{-m})]$ and $[\sigma_e(\alpha^{-m})]$ by placing predetermined values into each x of said separated even-numbered terms $\sigma_e(x)$ and odd-numbered terms $\sigma_0(x)$; and calculating

$\sigma(\alpha^{-m}) = \sigma_e(\alpha^{-m}) + \alpha^{-m}\sigma'_0(\alpha^{-m})$

$\sigma'(\alpha^{-m}) = \sigma'_0(\alpha^{-m})$

in order to provide $\sigma(\alpha^{-m})$ and $\sigma'(\alpha^{-m})$ simultaneously.

2. In a decoding method of the Reed Solomon Code including the steps calculating syndromes based on a parity check matrix and a received word, calculating an error location polynomial $\sigma(x)$ and an error evaluation polynomial $\omega(x)$ from said syndromes, obtaining an error pattern $e_p$ by a calculation of $[e_p = \omega(\alpha^{-p}) \cdot \sigma'(\alpha^{-p})]$ by the use of a formal first-order/differential polynomial $\sigma'(x)$ of said error location polynomial $\sigma(x)$ and said error evaluation polynomial $\omega(x)$, and correcting a symbol at an error position p, an improved decoding method comprising:

performing erasure correction by regarding error pointers in said error pattern as correct when a condition of

deg $\sigma^*(x) >$ deg $\omega^*(x)$

is established based upon $\omega^*(x) = \sigma^*(x) \cdot S(x)$, which is obtained by a multiplying an error location polynomial $\sigma^*(x)$ and a syndrome polynomial $S(x)$, where $\sigma^*(x)$ is the error location polynomial formed by values corresponding to error locations indicated by the pointers.

3. A decoder for decoding Reed Solomon Code in which syndromes are calculated by a parity check matrix and a received word, an error location polynomial $\sigma(x)$ and an error evaluation polynomial $\omega(x)$ are calculated, an error pattern $e_p$ is obtained by a calculation of $[e_p = \omega(\alpha^{-p})/\sigma'(\alpha^{-p})]$ using a formal first-order differential polynomial $\sigma(x)$ of the error location polynomial $\sigma'(x)$ and the error evaluation polynomial $\omega(x)$, so that a symbol of the received word at an error position p is corrected,

the decoder comprising means for separating even-numbered terms $\sigma_e(x)$ and odd numbered terms $\sigma_0(x)$ of said error location polynomial $\sigma(x)$;

means for obtaining $[\sigma_0(\alpha^{-m})]$ and $[\sigma_e(\alpha^{-m})]$ by placing predetermined values into each x of said separated even-numbered terms $\sigma_e(x)$ and odder-numbered terms $\sigma_0(x)$; and calculating

$\sigma(\alpha^{-m}) = \sigma_e(\alpha^{-m}) + \alpha^{-m}\sigma'_0(\alpha^{-m})$

$\sigma'(\alpha^{-m}) = \sigma'_0(\alpha^{-m})$

in order to provide $\sigma(\sigma^{-m})$ and $\sigma'(\sigma^{-m})$ simultaneously.

4. A decoder for Reed Solomon Code including the steps calculating syndromes based on a parity check matrix and a received word, calculating an error location polynomial $\sigma(x)$ and an error evaluation polynomial $\omega(x)$ from said syndromes, obtaining an error pattern $e_p$ by a calculation of $[e_p = \omega(\alpha^{-p})/\sigma'(\alpha^{-p})]$ by the use of a formal first-order differential polynomial $\sigma'(x)$ of said error location polynomial $\sigma(x)$ and said error evaluation polynomial $\omega(x)$, and correcting a symbol at an error position p, the decoder comprising:

means for performing erasure correction by regarding error pointers in said error pattern as correct when a condition of

$\deg \sigma^*(x) > \deg \omega^*(x)$

is established based upon $\omega^*(x) = \sigma^*(x).S(x)$, which is obtained by multiplying an error location polynomial $\sigma^*(x)$ and a syndrome polynomial $S(x)$, where $\sigma^*(x)$ is the error location polynomial formed by values corresponding to error locations indicated by the pointers.

*Fig. IA*

| 1 | 2 | 3 | | | P | | | n−1 | n |

*Fig. IB*

| 1 | $\alpha^{-1}$ | $\alpha^{-2}$ | | | | | | | |

$\alpha^{-(P-1)}$     $\alpha^{-(n-2)}$   $\alpha^{-(n-1)}$

*Fig. 2A*

*Fig. 2B*

| $\alpha^{11}$ | | $\alpha^{3}$ |

*Fig. 3A*

*Fig. 3B*

| $\alpha^{11}$ | | $\alpha^{3}$ |

*Fig. 3C*

*Fig. 4A*

*Fig. 4B*

| $\alpha^{11}$ | | $\alpha^{3}$ |

*Fig. 4C*

*Fig. 5A*

*Fig. 5B*

| $\alpha^{4}$ | $\alpha^{4}$ | $\alpha^{3}$ | $\alpha^{2}$ | $\alpha$ |

*Fig. 5C*

Fig. 6

# Fig. 7A

| | t0 | t1 | t2 | t3 | t4 | t5 | t6 | t7 | t8 | t9 |
|---|---|---|---|---|---|---|---|---|---|---|
| $\alpha^{-2i}$ | $\alpha^{-2.31}$ | $\alpha^{-2.30}$ | $\alpha^{-2.29}$ | $\alpha^{-2.28}$ | $\alpha^{-2.27}$ | $\alpha^{-2.26}$ | $\alpha^{-2.25}$ | $\alpha^{-2.24}$ | $\alpha^{-2.23}$ | $\alpha^{-2.22}$ |
| $\Sigma_0$ | $\sigma_7$ | $\sigma_6$ | $\sigma_3$ | $\sigma_1$ | | | | | | |
| $\Sigma_e$ | $\sigma_6$ | $\sigma_4$ | $\sigma_2$ | $\sigma_0$ | | | | | | |
| F0 | | $\alpha^{-62}$ | $\alpha^{-60}$ | $\alpha^{-58}$ | $\alpha^{-56}$ | $\alpha^{-54}$ | $\alpha^{-52}$ | $\alpha^{-50}$ | $\alpha^{-48}$ | $\alpha^{-46}$ |
| F10 | $\sigma_7$ | | | | | | | | | |
| F30 | $\sigma_6$ | | | | | | | | | |
| F1 | | | $\alpha^{-62}$ | $\alpha^{-60}$ | $\alpha^{-58}$ | $\alpha^{-56}$ | $\alpha^{-54}$ | $\alpha^{-52}$ | $\alpha^{-50}$ | $\alpha^{-48}$ |
| F11 | | $\sigma_7$ | | | | | | | | |
| F21 | | $\sigma_5$ | | | | | | | | |
| F31 | | $\sigma_6$ | | | | | | | | |
| F41 | | $\sigma_4$ | | | | | | | | |

EP 0 296 828 A2

EP 0 296 828 A2

# Fig. 7B

| | t0 | t1 | t2 | t3 | t4 | t5 | t6 | t7 | t8 | t9 | |
|---|---|---|---|---|---|---|---|---|---|---|---|
| F2 | | | | $\alpha^{-62}$ | $\alpha^{-60}$ | $\alpha^{-58}$ | $\alpha^{-56}$ | $\alpha^{-54}$ | $\alpha^{-52}$ | $\alpha^{-50}$ | |
| F12 | | | | $\sigma_7\alpha^{-62}+\sigma_5$ | $\sigma_7\alpha^{-60}+\sigma_5$ | $\sigma_7\alpha^{-58}+\sigma_5$ | $\sigma_7\alpha^{-56}+\sigma_5$ | $\sigma_7\alpha^{-54}+\sigma_5$ | $\sigma_7\alpha^{-52}+\sigma_5$ | $\sigma_7\alpha^{-50}+\sigma_5$ | |
| F22 | | | | $\sigma_3$ | | | | | | | |
| F32 | | | | $\sigma_6\alpha^{-62}+\sigma_4$ | $\sigma_6\alpha^{-60}+\sigma_4$ | $\sigma_6\alpha^{-58}+\sigma_4$ | $\sigma_6\alpha^{-56}+\sigma_4$ | $\sigma_6\alpha^{-54}+\sigma_4$ | $\sigma_6\alpha^{-52}+\sigma_4$ | $\sigma_6\alpha^{-50}+\sigma_4$ | |
| F42 | | | | $\sigma_2$ | | | | | | | |
| F3 | | | | | $\alpha^{-62}$ | $\alpha^{-60}$ | $\alpha^{-58}$ | $\alpha^{-56}$ | $\alpha^{-54}$ | $\alpha^{-52}$ | |
| F13 | | | | | $(\sigma_7\alpha^{-62}+\sigma_5)\cdot\alpha^{-62}+\sigma_3$ | $(\sigma_7\alpha^{-60}+\sigma_5)\cdot\alpha^{-60}+\sigma_3$ | $(\sigma_7\alpha^{-58}+\sigma_5)\cdot\alpha^{-58}+\sigma_3$ | $(\sigma_7\alpha^{-56}+\sigma_5)\cdot\alpha^{-56}+\sigma_3$ | $(\sigma_7\alpha^{-54}+\sigma_5)\cdot\alpha^{-54}+\sigma_3$ | $(\sigma_7\alpha^{-52}+\sigma_5)\cdot\alpha^{-52}+\sigma_3$ | |
| F23 | | | | | $\sigma_1$ | | | | | | |
| F33 | | | | | $(\sigma_6\alpha^{-62}+\sigma_4)\cdot\alpha^{-62}+\sigma_2$ | $(\sigma_6\alpha^{-60}+\sigma_4)\cdot\alpha^{-60}+\sigma_2$ | $(\sigma_6\alpha^{-58}+\sigma_4)\cdot\alpha^{-58}+\sigma_2$ | $(\sigma_6\alpha^{-56}+\sigma_4)\cdot\alpha^{-56}+\sigma_2$ | $(\sigma_6\alpha^{-54}+\sigma_4)\cdot\alpha^{-54}+\sigma_2$ | $(\sigma_6\alpha^{-52}+\sigma_4)\cdot\alpha^{-52}+\sigma_2$ | |
| F43 | | | | | $\sigma_0$ | | | | | | |

# Fig. 7C

| | t0 | t1 | t2 | t3 | t4 | t5 | t6 | t7 | t8 | t9 |
|---|----|----|----|----|----|----|----|----|----|----|
| F4 | | | | | | $\alpha^{-31}$ | $\alpha^{-30}$ | $\alpha^{-29}$ | $\alpha^{-28}$ | $\alpha^{-27}$ |
| F14 | | | | | | $\sigma'_0(\alpha^{-31})$ | $\sigma_b(\alpha^{-30})$ | $\sigma'_0(\alpha^{-29})$ | $\sigma_b(\alpha^{-28})$ | $\sigma'_0(\alpha^{-27})$ |
| F24 | | | | | | $\sigma_e(\alpha^{-31})$ | $\sigma_e(\alpha^{-30})$ | $\sigma_e(\alpha^{-29})$ | $\sigma_e(\alpha^{-28})$ | $\sigma_e(\alpha^{-27})$ |
| F54 | | | | | | $\omega'_0(\alpha^{-31})$ | $\omega'_0(\alpha^{-30})$ | $\omega'_0(\alpha^{-29})$ | $\omega_0(\alpha^{-28})$ | $\omega'_0(\alpha^{-27})$ |
| F64 | | | | | | $\omega_e(\alpha^{-31})$ | $\omega_e(\alpha^{-30})$ | $\omega_e(\alpha^{-29})$ | $\omega_e(\alpha^{-28})$ | $\omega_e(\alpha^{-27})$ |
| F25 | | | | | | $\sigma(\alpha^{-31})$ | $\sigma(\alpha^{-30})$ | $\sigma(\alpha^{-29})$ | $\sigma(\alpha^{-28})$ | |
| NOR | | | | | | | | | | |
| F45 | | | | | | $\sigma'(\alpha^{-31})^{-1}$ | $\sigma'(\alpha^{-30})^{-1}$ | $\sigma'(\alpha^{-29})^{-1}$ | $\sigma'(\alpha^{-28})^{-1}$ | |
| F55 | | | | | | $\omega(\alpha^{-31})$ | $\omega(\alpha^{-30})$ | $\omega(\alpha^{-29})$ | $\omega(\alpha^{-28})$ | |
| F65 | | | | | | | D31 | D30 | D29 | D28 |
| F66 | | | | | | | | D31 | D30 | $D29 + \dfrac{\omega(\alpha^{-29})}{\sigma'(\alpha^{-29})}$ |

EP 0 296 828 A2

EP 0 296 828 A2

Fig. 8

21 — $Np \leqq 2t$ ?

NO →

YES

28 — CALCULATION OF $\sigma^*(x)$

29 — CALCULATION OF $\sigma^*(x) \times S(x) = \omega^*(x)$

30 — $\deg \sigma^*(x) > \deg \omega^*(x)$ ?

NO

YES

31 — $e_{PL} = \dfrac{\omega^*(\alpha^{-PL})}{\sigma'^*(\alpha^{-PL})}$

22 — CALCULATION OF $\sigma(x)$, $\omega(x)$

23 — $\deg \sigma(x) < t$ ?

NO →

YES

24 — SEARCH $x = \alpha^{-Pi}$ SATISFYING $\sigma(x) = 0$

25 — CODE LENGTH n $0 \leqq pi < n$ ?

NO →

YES

26 — $e_{Pi} = \dfrac{\omega(\alpha^{-Pi})}{\sigma'(\alpha^{-Pi})}$

27 — SET ERROR CORRECTION FLAGS AT ALL LOCATION INDICATED BY POINTER

# Fig. 9

FIRST STAGE · SECOND STAGE · (2t-1)th STAGE

$\cdots 0,0,0,\alpha^{-\ell_1},1 \longrightarrow \boxed{} \cdots \rightarrow \sigma_{2t}, \sigma_{2t-1} \cdots \sigma_1, \sigma_0$

32 · 33

# Fig. 10A

$a,1 \Rightarrow a,1$

$0 \rightarrow$ AD · $1, a+b, ab$

# Fig. 10B

$\cdots 0,0,0,a,1$

EP 0 296 828 A2

EP 0 296 828 A2

# Fig. 11

FIRST STAGE  SECOND STAGE  (2t-1)th STAGE

$\cdots 0,0,0,1,\alpha^{-\ell 1}$

$\alpha^{-\ell 2}$  $\alpha^{-\ell 3}$  $\alpha^{-\ell 2t-1}$  $\alpha^{-\ell 2t}$

$\sigma_0, \sigma_1, \cdots \sigma_{2t-1}, \sigma_{2t}$

34  35

F/F  F/F  AD  F/F  F/F  AD  F/F  F/F  AD  F/F  F/F  AD  F/F  F/F

# Fig. 12A

$a, 1$

$b$  ML  $1$  ML  $b$  ML  AD

$0$

$1, a+b, ab$

AD  F/F  F/F  AD

# Fig. 12B

$1, a$  $1, a$

$1$  ML  $b$  ML  AD  $b$  ML  AD

$0$

$ab, a+b, 1$

AD  F/F  F/F

# Fig. 12C

$b$  $c$  $d$

ML  ML  ML

$\cdots 0,0,1,a$  $abcd, (abc + bcd + cda + acd), \cdots$

F/F  AD  F/F  F/F  AD  F/F  F/F  AD

EP 0 296 828 A2

# Fig. 13

$\sigma_0, \sigma_1 \cdots \sigma_{2t-2}, \sigma_{2t-1}$

# Fig. 14

$\sigma_{2t-1}, \sigma_{2t-2}, \cdots \sigma_1, \sigma_0$